(19) Europäisches Patentamt / European Patent Office / Office européen des brevets

(11) **EP 2 347 638 B1**

(12) **EUROPEAN PATENT SPECIFICATION**

(45) Date of publication and mention
of the grant of the patent:
**05.12.2018 Bulletin 2018/49**

(51) Int Cl.:
*H05K 3/10* *(2006.01)*     *C23C 18/16* *(2006.01)*
*C23C 18/31* *(2006.01)*     *H05K 1/03* *(2006.01)*

(21) Application number: **09821387.9**

(22) Date of filing: **19.10.2009**

(86) International application number:
**PCT/US2009/061172**

(87) International publication number:
**WO 2010/045639 (22.04.2010 Gazette 2010/16)**

(54) **METHOD AND APPARATUS FOR REACTING THIN FILMS ON LOW-TEMPERATURE SUBSTRATES AT HIGH SPEEDS**

VERFAHREN UND VORRICHTUNG ZUR REAKTION VON DÜNNSCHICHTEN AUF NIEDRIGTEMPERATURSUBSTRATEN BEI HOHER GESCHWINDIGKEIT

PROCÉDÉ ET APPAREIL POUR FAIRE RÉAGIR DES FILMS MINCES SUR DES SUBSTRATS BASSE TEMPÉRATURE À DE GRANDES VITESSES

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **17.10.2008 US 196531 P**

(43) Date of publication of application:
**27.07.2011 Bulletin 2011/30**

(73) Proprietor: **Ncc Nano, Llc**
**Dallas, TX 75250 (US)**

(72) Inventor: **SCHRODER, Kurt, A.**
**Coupland**
**TX 78615 (US)**

(74) Representative: **Hackney, Nigel John**
**Mewburn Ellis LLP**
**City Tower**
**40 Basinghall Street**
**London EC2V 5DE (GB)**

(56) References cited:
**WO-A1-2008/018719**     **US-A- 4 526 807**
**US-A1- 2004 185 388**     **US-A1- 2004 231 141**
**US-A1- 2004 234 916**     **US-A1- 2008 020 304**
**US-A1- 2008 020 304**

**Description**

**BACKGROUND OF THE INVENTION**

**1. Technical Field**

The present invention relates to curing methods in general, and, in particular, to a method and apparatus for reacting thin films on low-temperature substrates at high speeds.

**2. Description of Related Art**

One approach to making electrical conductors on circuits is to print metal-containing ink onto a substrate, and to then heat the substrate for sintering the particles in the metal-containing ink to form a conducting path. Generally, most metals suitable for electrical conduction need to be heated to a very high temperature, which is often in the range of a couple hundred degrees centigrade of their melting point. For example, silver is a good metal for making conductive traces because it can be heated in air and that its oxides, which are comparatively low in conductivity, decompose at relatively low temperatures. In addition, the fact that silver being the most electrically conductive metal often outweighs its high cost when comes to choosing a metal for making conductive traces.

US 2008/0020304 A1 describes nanomaterial compositions generally comprising carbon and a metal. The composition can be exposed to pulsed emissions to react, activate, combine, or sinter a nanomaterial composition. The nanomaterial compositions can be utilised at ambient temperature or under other means to cause such reaction, activation, combination, or sintering to occur.

Another metal that is being constantly pursued in the manufacturing of conductive traces is copper because of its low cost. Copper has about 90% of the conductivity of silver but is usually 50 to 100 times cheaper than silver on a mass basis. However, silver inks still dominate the printed electronics market because the additional cost of making and processing the copper inks to avoid oxidation is generally higher than the difference in cost of the bulk materials. Basically, when copper particles are heated in air, they oxidize before they sinter, which results in a non-conductor.

Consequently, it would be desirable to provide an improved method for making conductive traces using relatively low cost metals such as copper.

**SUMMARY OF THE INVENTION**

The present invention provides a method of reacting a thin film according to claim 1. The present invention also provides a curing apparatus according to claim 8. Further aspects of the invention are set out in the dependent claims.

In accordance with a preferred embodiment of the present invention, a gaseous atmosphere is initially provided. A layer of thin film located on top of a low-temperature substrate is then transported through the gaseous atmosphere. When the layer of thin film is being transported through the gaseous atmosphere, the layer of thin film is exposed to multiple pulsed electromagnetic emissions to allow the layer of thin film to be chemically reacted with the gaseous atmosphere.

All features and advantages of the present invention will become apparent in the following detailed written description.

**BRIEF DESCRIPTION OF THE DRAWINGS**

The invention itself, as well as a preferred mode of use, further objects, and advantages thereof, will best be understood by reference to the following detailed description of an illustrative embodiment when read in conjunction with the accompanying drawings, wherein:

Figure **1** is a diagram of a curing apparatus, in accordance with a preferred embodiment of the present invention; and

Figure **2** is a high-level logic flow diagram of a method for reacting thin films on a low-temperature substrate, in accordance with a preferred embodiment of the present invention.

**DETAILED DESCRIPTION OF A PREFERRED EMBODIMENT**

It is well known that some metal oxides can be reduced by hydrogen or hydrocarbons at an elevated temperature if they have a positive reduction potential. Examples include oxides of copper, gold, platinum, and palladium. Copper can be made by mixing copper oxide bearing ore with charcoal via a heating process. When oxidized copper particles or even pure copper oxide is heated in a reducing atmosphere, the particles can sinter to form a conductor.

When making thin film conductors by printing copper particles, a very conductive trace can be formed if the particles are heated to their sintering temperature in an inert or reducing atmosphere. Since the melting point of copper is nearly 1,085 °C, the temperature required for sintering demands that only high-temperature substrates, such as glass or ceramic, can be utilized. This relatively high temperature requirement on substrates prevents the usage of inexpensive substrates such as paper or plastic.

Alternatively, if copper oxide is placed on a low-temperature substrate, the copper oxide can be heated to near the substrate's decomposition temperature and the low-temperature substrate can be placed in a reducing atmosphere. However, the low temperature dramatically increases the amount of time needed to minutes or even hours depending on the substrate thickness. Still, at these low temperatures, sintering is very limited. The substrate temperature and gas atmosphere requirements can be overcome if an intense, short pulse of light is utilized to cure the substrate. Unfortunately, these approaches do nothing to address the residual oxide in the copper film. Reducible metal oxide can be placed between two electrical contacts in a hydrogen atmosphere, and electrical current can be repetitively pulsed through the oxide to heat the oxide and to reduce the oxide. However, this technique requires electrical contacts and its throughput is relatively limited. Thus, there is a need to reduce metal oxide on low-temperature substrates with a high throughput.

For the present invention, curing is defined as thermal processing, which includes reacting a thin film with a gaseous atmosphere. Thin film is defined as a coating less than 100 microns thick. A low-temperature substrate can be made of paper, plastic or polymer. An electromagnetic emission may include electromagnetic radiation comprising gamma rays, x-rays, ultraviolet, visible light, infrared, millimeter waves, microwaves, or radiowaves. Electromagnetic emission sources include lasers, induction heaters, microwave generators, flashlamps, light emitting diodes, etc.

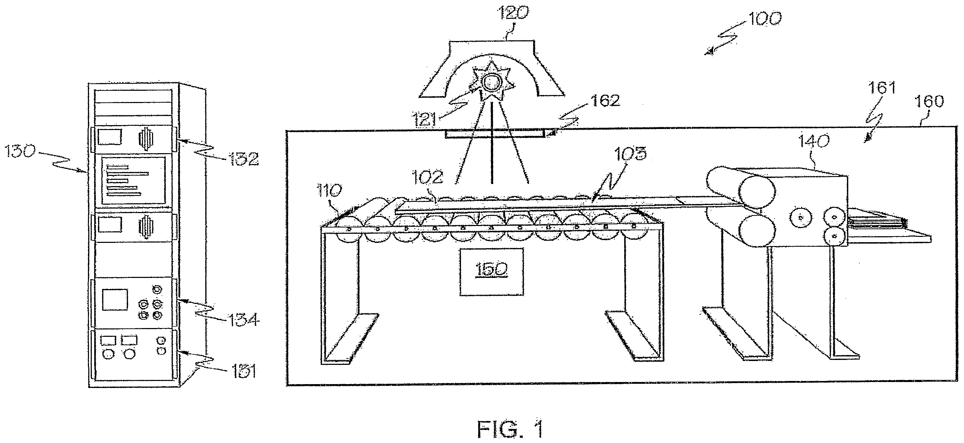

Referring now to the drawings and in particular to Figure **1,** there is depicted a diagram of a curing apparatus, in accordance with a preferred embodiment of the present invention. As shown, a curing apparatus **100** includes a conveyor belt system **110,** a strobe head **120,** a relay rack **130** and a reel-to-reel feeding system **140.** Curing apparatus **100** is capable of curing a thin film **102** mounted on a low-temperature substrate **103** situated on a web being moved across a conveyor belt at a relative high speed. Conveyer belt system **110** can operate at speeds from 0 to 1,000 ft/min, for example, to move substrate **103.** Curing apparatus **100** can accommodate a web of any width in 6-inch increments. Thin film **102** can be added on substrate **103** by one or combinations of existing technologies such as screen printing, inkjet printing, gravure, laser printing, xerography, pad printing, painting, dip-pen, syringe, airbrush, flexographic, chemical vapor deposition (CVD), evaporation, sputtering, etc.

Strobe head **120,** which is preferably water cooled, includes a high-intensity pulsed xenon flash lamp **121** for curing thin film **102** located on substrate **103.** Pulsed xenon flash lamp **121** can provide pulses for different intensity, pulse length, and pulse repetition frequency. For example, pulsed xenon flash lamp **121** can provide 10 microseconds to 50 milliseconds pulses with a 3" by 6" wide beam at a pulse repetition rate of up to 1 kHz. The spectral content of the emissions from the pulsed xenon flash lamp **121** ranges from 200 nm to 2,500 nm. The spectrum can be adjusted by replacing the quartz lamp with a cerium doped quartz lamp to remove most of the emission below 350 nm. The quartz lamp can also be replaced with a sapphire lamp to extend the emission from approximately 140 nm to approximately 4,500 nm. Filters may also be added to remove other portions of the spectrum. Flash lamp **121** can also be a water wall flash lamp that is sometimes referred to a Directed Plasma Arc (DPA) lamp.

Relay rack **130** includes an adjustable power supply **131,** a conveyor control module **132,** and a strobe control module **134.** Adjustable power supply **131** can produce pulses with an energy of up to 4 kilojoules per pulse. Adjustable power supply **131** is connected to pulsed xenon flash lamp **121,** and the intensity of the emission from pulsed xenon flash lamp **121** can be varied by controlling the amount of current passing through pulsed xenon flash lamp **121.**

Adjustable power supply **131** controls the emission intensity of pulsed xenon flash lamp **121.** The power, pulse duration and pulse repetition frequency of the emission from pulsed xenon flash lamp **121** are electronically adjusted and synchronized to the web speed to allow optimum curing of thin film **102** without damaging substrate **103,** depending on the optical, thermal and geometric properties of thin film **102** and substrate **103.**

During curing operation, substrate **103** as well as thin film **102** are being moved onto conveyor belt system **110.** Conveyor belt system **110** moves thin film **102** under strobe head **120** where thin film **102** is cured by rapid pulses from pulsed xenon flash lamp **121.** The power, duration and repetition rate of the emissions from pulsed xenon flash lamp **121** are controlled by strobe control module **134,** and the speed at which substrate **103** is being moved past strobe head **120** is determined by conveyor control module **132.**

A sensor **150,** which can be a mechanical, electrical, or optical sensor, is utilized to sense the speed of conveyor belt system **110.** For example, the conveyor belt speed of conveyor belt system **110** can be sensed by detecting a signal from a shaft encoder connected to a wheel that made contact with the moving conveyor belt. In turn, the pulse repetition rate can be synchronized with the conveyor belt speed of conveyor belt system **110** accordingly. The synchronization of the strobe pulse rate $f$ is given by:

$$f = \frac{0.2 * S * O}{W}$$

where

$f$ =      strobe pulse rate [Hz]
$S$ =      web speed [ft/min]
$O$ =      overlap factor
$W$ =      curing head width [in]

Overlap factor O is the average number of strobe pulses that are received by a substrate. For example, with a web speed of 200 ft/min, and overlap factor of 5, and a curing head width of 2.75 inches, the pulse rate of a strobe is 72.7 Hz.

An enclosure **160** surrounds substrate **103** and contains a reducing atmosphere **161**. A transparent window **162** passes light from flash lamp **121**. When flash lamp **121** is pulsed, film **102** is momentarily heated and chemically reacts with atmosphere 161. When a rapid pulse train is combined with moving substrate **103,** a uniform cure can be attained over an arbitrarily large area as each section of thin film **102** is exposed to multiple pulses, which approximates a continuous curing system such as an oven.

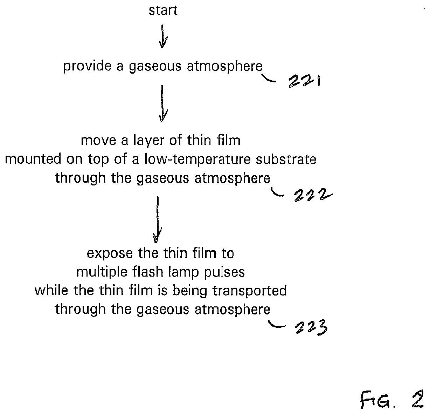

With reference now to Figure **2,** there is depicted a high-level logic flow diagram of a method for reacting thin films on a low-temperature substrate, in accordance with a preferred embodiment of the present invention. Initially, a gaseous atmosphere containing a reducing gas, such as reducing atmosphere **161** from Figure **1,** is provided, as shown in block **221.** Preferably, the gaseous atmosphere contains hydrogen or a hydrocarbon such as methane, propane, etc.

Next, a layer of thin film located on top of a low-temperature substrate is move through the gaseous atmosphere, as depicted in block **222**. The thin film preferably contains a reducible metal oxide such as copper oxide ($CuO$), gold oxide ($Ag_2O$), platinum oxide ($PtO$) and palladium oxide ($PdO$), etc. For reasons of economy, copper is desirable as a conductor for printed electronics. A printed copper film often contains copper oxide, which is a barrier to electronic conduction. The low-temperature substrate can be made of polymer or paper.

Each segment (*i.e.,* the curing head width) of the layer of thin film is then exposed to at least one pulse from a flash lamp, such as flash lamp **121** from Figure **1,** while the layer of thin film is being transported through the gaseous atmosphere, as shown in block **223,** to allow the layer of thin film to be chemically reacted with the gaseous atmosphere. Basically, the pulses from the strobe system reduce the thin film of metal oxide, such as copper oxide, on the low-temperature substrate to form a conductive metal film, such as copper film, in less than one second without damaging the low-temperature substrate.

When reducing a metal oxide to a metal in a hydrogen environment, the speed at which the reaction progresses is diffusion limited. The diffusion rate is related to the temperature of the curing system. When an oven is utilized, the temperature is limited by the decomposition temperature of the low-temperature substrate. The pulsed light heats the metal oxide to a very high temperature without decomposing the low-temperature substrate. This dramatically reduces the time to reduce the metal oxide.

As has been described, the present invention provides a method and apparatus for reacting thin films on low-temperature substrates. One advantage of the present invention is that a metal thin film can be obtained even when pure metal oxide is initially deposited. One of the motivations to deposit metal oxide particles is that they are more readily available than their metal counterparts, particularly when they are in a nanoparticle form. It is particularly difficult to make very fine (tens of nm) metal particles while maintaining their purity. The very fine metal particles are usually coated with either an oxide and/or a capping group. In addition, metal oxide particles can be more easily dispersed, and can be more easily printed on a variety of substrates.

Another advantage of the present invention is that it requires no registration. If the thin film is a printed pattern, only that pattern is reacted while the unprinted portions of the low-temperature substrate that generally are less absorptive of the light pulses are left cool.

While the reduction of a metal oxide is shown to be in a reducing atmosphere to form a metal film, other film/reactive gas combinations are also possible. Other examples include:

(1) Reduction with $H_2$ (or creation of hydrides for $H_2$ storage materials).

(2) Oxidation with $O_2$ (for dielectrics).

(3) Carburization with carbonaceous gases for the formation of carbides. The partial pressure of $O_2$ within the carbonaceous gas stream for the formation of oxycarbides.

(4) Nitridation with ammonia or amines for the formation of nitrides. The partial pressure of $O_2$ within the ammonia or amine gas stream for the formation of oxynitrides.

(5) Formation of chalcogenides from various precursor gases. Chalcogenides are sulfides ($S^{2-}$), selenides ($Se^{2-}$), and tellurides ($Te^{2-}$). This covers a large family of semiconductors (II - VI semiconductors), *e.g.,* ZnS, ZnSe, CdS, CdSe, CdTe, etc.

(6) Formation of pnictides from various precursor gases. Pnictides are phosphides ($P^{3-}$), arsenides ($As^{3-}$), and antimonides ($Sb^{3-}$). This also covers the synthesis of a large family of semiconductors (III - V class semiconductors), *e.g.,* GaP, GaAs, InP, InAs, InSb, etc.

While the invention has been particularly shown and described with reference to a preferred embodiment, it will be understood by those skilled in the art that various changes in form and detail may be made therein without departing from the scope of the invention.

**Claims**

1. A method for reacting a thin film on a low-temperature substrate, said method comprising:

providing an enclosure (160) containing a reactive gas;

moving a layer of thin film mounted on a low-temperature substrate through said enclosure, wherein said low-temperature substrate is made of one of paper, plastic and polymer; and exposing said layer of thin film to a pulsed electromagnetic emission while said layer of thin film is being moved in relation to a source (121) of said pulsed electromagnetic emissions within said enclosure (160) to chemically react said layer of thin film with said gas within said enclosure.

2. The method of Claim 1, wherein said gas contains hydrogen.

3. The method of Claim 1, wherein said gas contains hydrocarbon gas.

4. The method of Claim 1, wherein said thin film is a metal compound containing a metal having a positive reduction potential.

5. The method of Claim 4, wherein said metal compound is copper oxide.

6. The method of Claim 4, wherein said metal compound is platinum oxide.

7. The method of Claim 4, wherein said metal compound is palladium oxide.

8. A curing apparatus comprising:

an enclosure (160) for containing a reactive gas; a strobe head (120) having a flash lamp (121) for providing a pulsed electromagnetic emission to a layer of thin film mounted on a low-temperature substrate to allow said layer of thin film to be chemically reacted with said gas, wherein said low-temperature substrate is made of one of paper, plastic and polymer; and a conveyor system (110) for moving said layer of thin film within said enclosure (160) in relation to said strobe head (120); and a strobe control module (134) for controlling power, duration, repetition rate and the number of pulses of electromagnetic emission generated by said flash lamp (121).

9. The curing apparatus of Claim 8, wherein said gas contains hydrogen.

10. The curing apparatus of Claim 8, wherein said gas contains hydrocarbon gas.

11. The curing apparatus of Claim 8, wherein said thin film is a metal compound containing a metal having a positive reduction potential.

**Patentansprüche**

1. Verfahren zum Umsetzen eines Dünnfilms auf einem Niedrigtemperatursubstrat, wobei das Verfahren Folgendes umfasst:

das Bereitstellen einer Umhüllung (160), die reaktives Gas enthält; das Bewegen einer Dünnfilmschicht, die auf einem Niedrigtemperatursubstrat angebracht ist, durch die Umhüllung, wobei das Niedrigtemperatursubstrat entweder aus Papier, Kunststoff oder Polymer hergestellt ist; und das Aussetzen dieser Dünnfilmschicht gegenüber einer gepulsten elektromagnetischen Emission, während die Dünnfilmschicht in Bezug auf eine Quelle (121) der gepulsten elektromagnetischen Emissionen in der Umhüllung (160) bewegt wird, um die Dünnfilmschicht mit dem Gas in der Umhüllung chemisch umzusetzen.

2. Verfahren nach Anspruch 1, wobei das Gas Wasserstoff enthält.

3. Verfahren nach Anspruch 1, wobei das Gas Kohlenwasserstoffgas enthält.

4. Verfahren nach Anspruch 1, wobei der Dünnfilm eine Metallverbindung ist, die ein Metall mit einem positiven Reduktionspotential enthält.

5. Verfahren nach Anspruch 4, wobei die Metallverbindung Kupferoxid ist.

6. Verfahren nach Anspruch 4, wobei die Metallverbindung Platinoxid ist.

7. Verfahren nach Anspruch 4, wobei die Metallverbindung Palladiumoxid ist.

8. Härtevorrichtung, die Folgendes umfasst:

eine Umhüllung (160), um ein reaktives Gas zu fassen; einen Stroboskopkopf (120) mit einer Blitzlampe (121) für das Bereitstellen einer gepulsten elektromagnetischen Emission an eine Dünnfilmschicht, die auf einem Niedrigtemperatursubstrat angebracht ist, um die chemische Umsetzung der Dünnfilmschicht mit dem Gas zu ermöglichen, wobei das Niedrigtemperatursubstrat aus entweder Papier, Kunststoff oder Polymer hergestellt ist; und ein Fördersystem (110) zum Bewegen der Dünnfilmschicht in der Umhüllung (160) in Bezug auf den Stroboskopkopf (120); und ein Stroboskopsteuermodul (134) für die Steuerung von Leistung, Dauer, Wiederholungsrate und Anzahl der Impulse der elektromagnetischen Emission, die von der Blitzlampe (121) erzeugt wird.

9. Härtevorrichtung nach Anspruch 8, wobei das Gas Wasserstoff enthält.

10. Härtevorrichtung nach Anspruch 8, wobei das Gas Kohlenwasserstoffgas enthält.

11. Härtevorrichtung nach Anspruch 8, wobei der Dünnfilm eine Metallverbindung ist, die ein Metall mit einem positiven Reduktionspotential enthält.

**Revendications**

1. Procédé pour faire réagir un film mince sur un substrat basse température, ledit procédé comprenant les étapes consistant à :

   fournir une enceinte (160) contenant un gaz réactif ;
   déplacer une couche de film mince montée sur un substrat basse température à travers ladite enceinte, ledit substrat basse température étant constitué d'un parmi du papier, du plastique et du polymère ; et
   exposer ladite couche de film mince à une émission électromagnétique pulsée pendant que ladite couche de film mince est déplacée par rapport à une source (121) desdites émissions électromagnétiques puisées à l'intérieur de ladite enceinte (160) afin de faire réagir chimiquement ladite couche de film mince avec ledit gaz à l'intérieur de ladite enceinte.

2. Procédé selon la revendication 1, dans lequel ledit gaz contient de l'hydrogène.

3. Procédé selon la revendication 1, dans lequel ledit gaz contient un gaz hydrocarbure.

4. Procédé selon la revendication 1, dans lequel ledit film mince est un composé métallique contenant un métal ayant un potentiel de réduction positif.

5. Procédé selon la revendication 4, dans lequel ledit composé métallique est l'oxyde de cuivre.

6. Procédé selon la revendication 4, dans lequel ledit composé métallique est l'oxyde de platine.

7. Procédé selon la revendication 4, dans lequel ledit composé métallique est l'oxyde de palladium.

8. Appareil de durcissement, comprenant :

   une enceinte (160) destinée à contenir un gaz réactif ;
   une tête stroboscopique (120) comportant une lampe éclair (121) pour fournir une émission électromagnétique pulsée à une couche de film mince montée sur un substrat basse température afin de permettre à ladite couche de film mince de réagir chimiquement avec ledit gaz, dans lequel ledit substrat basse température est constitué d'un parmi du papier, du plastique et du polymère ; et
   un système de convoyeur (110) pour déplacer ladite couche de film mince à l'intérieur de ladite enceinte (160) en relation avec ladite tête stroboscopique (120) ; et
   un module de commande stroboscopique (134) pour contrôler la puissance, la durée, le taux de répétition et le nombre d'impulsions d'émission électromagnétique générées par ladite lampe éclair (121).

9. Appareil de durcissement selon la revendication 8, dans lequel ledit gaz contient de l'hydrogène.

10. Appareil de durcissement selon la revendication 8, dans lequel ledit gaz contient un gaz hydrocarbure.

11. Appareil de durcissement selon la revendication 8, dans lequel ledit film mince est un composé de métal contenant un métal ayant un potentiel de réduction positif.

FIG. 1

start

↓

provide a gaseous atmosphere ⟍ 221

↓

move a layer of thin film
mounted on top of a low-temperature substrate
through the gaseous atmosphere ⟍ 222

↓

expose the thin film to
multiple flash lamp pulses
while the thin film is being transported
through the gaseous atmosphere ⟍ 223

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080020304 A1